# EUROPEAN PATENT SPECIFICATION

(11) **EP 1 696 054 B1**
(45) Date of publication and mention of the grant of the patent: **26.10.2011**
(21) Application number: 06002493.2
(22) Date of filing: 07.02.2006
(51) Int. Cl.: C25D 17/06

(54) **Electroplating apparatus**
Vorrichtung zur Elektroplattierung
Dispositif d'électroplacage

(30) Priority: 25.02.2005 JP 2005051215
(43) Date of publication of application: 30.08.2006
(73) Proprietor: YAMAMOTO-MS Co., Ltd., Tokyo (JP)
(72) Inventor: Yamamoto, Wataru, Shibuya-ku, Tokyo (JP); Akiyama, Katsunori, Shibuya-ku, Tokyo (JP); Harada, Fumio, Shibuya-ku, Tokyo (JP)
(74) Representative: Strehl Schübel-Hopf & Partner

(56) References cited:
- EP-A- 1 386 984
- WO-A-03/034478
- WO-A-03/103025
- US-A1- 2004 037 682

## Description

### BACKGROUND OF THE INVENTION

### 1. FIELD OF THE INVENTION

The present invention relates to an electroplating apparatus for performing electroplating and anodic oxidation on surfaces of, for example, wafers, glass substrates, and ceramic substrates.

### 2. DESCRIPTION OF THE RELATED ART

In recent years, electroplating technologies are applied to various kinds of technical fields, including wiring technologies in semi-conductors. In the field of semi-conductors, wiring pitches are required to be reduced to accomplish high integration and performance. For example, in a wiring technology employed in latest years, an interlayer insulated film is formed, and then dry etching process is performed to form wiring grooves into which wiring material is electroplated and filled.

To achieve such an electroplating technology, it is required to electroplate wiring material evenly in grooves formed on an object to be electroplated. Therefore, the applicant has proposed an electroplating apparatus which can form an even electroplating film on a surface to be electroplated of an object to be electroplated. (Refer to JP 2003-301299A, for example.)

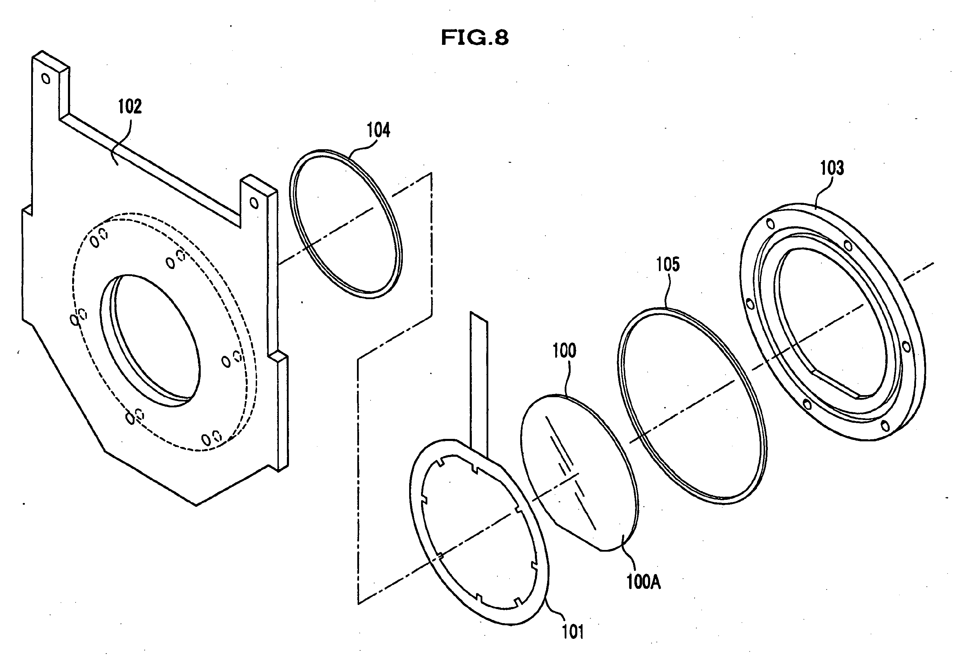

As shown in FIG.8, the electroplating apparatus includes a cathode conductor 101 which conducts electricity to a surface 100A to be electroplated of a wafer 100, which is an object to be electroplated, a first insulator 102 (referred as an insulator 102 hereafter) which covers a front surface side (the side of the surface 100A) of the wafer 100 and holds the cathode conductor 101, and a second insulator 103 (referred as a back cover 103 hereafter) which covers a back surface side (the opposite side of the surface 100A) of the wafer 100 and holds the wafer 100.

Here, a portion of the cathode other than the surface 100A of the wafer 100 is blocked from electroplating solution by a first O-ring 104 attached to the insulator 102 and a second O-ring 105 attached to the back cover 103 so as to be prevented from being electroplated.

By the way, in the electroplating apparatus in JP 2003-301299A, plural screws (not shown in the FIG.) are tightened to affix the back cover 103 to the insulator 102. Thus, the first O-ring 104 and the second O-ring 105 can be affixed respectively to the insulator 102 and the back cover 103 with preferably even pushing pressure circumferentially.

However, it is difficult to equalize tightening pressures of plural screws, so as to cause the tightening pressures of the plural screws to be unbalanced actually. When the tightening pressures of the plural screws are thus unbalanced, the back cover 103 is affixed to the insulator 102 unevenly so as to cause the pushing pressure (tightening margin) of the first O-ring 104 and the second O-ring 105 to be uneven circumferentially. Accordingly, sealing performance of the first O-ring 104 and the second O-ring 105 becomes low. As a result, in electroplating the wafer 100, there is a problem that electroplating solution infiltrates into an area other than the surface 100A through the first O-ring 104 or the second O-ring 105, causing the area other than the surface 100A to be electroplated.

A large-sized wafer 100 in recent years requires manufacturing a large-sized electroplating apparatus. However, since the larger-sized electroplating apparatus requires more screws, the tightening pressures of the screws become more uneven. As a result, sealing performance of the first O-ring 104 and the second O-ring 105 is further degraded. Therefore, the area other than the surface 100A is more likely to be electroplated.

US 2004/0037682 A1 discloses an electroplating apparatus which has the features included in the first part of claim 1. The known apparatus has suction caps and vacuum-attracting cavities for holding the wafer to be electroplated. Contact portions for conducting electricity to the wafer are exposed within the opening receiving the wafer and may thus be contaminated by the electroplating solution.

### SUMMARY OF THE INVENTION

With consideration of the above-mentioned problem, it is an object of the present invention to provide an electroplating apparatus which certainly prevents an area other than a surface to be electroplated of an object to be electroplated from being electroplated so as to improve performance and reliability.

The above-mentioned problem is solved by the electroplating apparatus defined in claim 1.

In such a configuration, a pump provided in the vacuum passage can vacuum air in the space surrounded by the first insulated plate, the second insulated plate, the inner seal, and the outer seal so as to make and keep the air pressure in the space negative. Consequently, the whole inner seal can be affixed to the object to be electroplated with even pushing pressure while the whole outer seal can be affixed to the first insulated plate and the second insulated plate with even pushing pressure. Therefore, high sealing performance of the inner seal and the outer seal can be maintained in order to solve the problem that electroplating solution infiltrates into the space so as to cause the area other than the surface to be electroplated of the object to be electroplated. The object to be electroplated may be connected to the negative electrode of a power source so that surface of the object to be electroplated can be electroplated. In addition, the object to be electroplated may be also connected to a positive electrode of a power source so that an anodic film, which is an oxide coating film, can be formed on the surface of the object to be electroplated.

The electroplating apparatus may include an open/close valve in the vacuum passage. In the electroplating apparatus, the open/close valve may connect the vacuum passage to a pump and disconnect the vacuum passage from the pump.

In such a configuration, in vacuuming the air in the space surrounded by the first insulated plate, the second insulated plate, the inner seal, and the outer seal, the open/close valve is opened to allow the pump to vacuum the air in the space. In addition, when the air pressure in the space has become negative sufficiently, the open/close valve is closed so as to keep the air pressure in the space negative. Accordingly, the pump does not need to keep working.

In the electroplating apparatus, a fitting recess into which the object to be electroplated is fit may be formed in the second insulated plate. Moreover, depth of the fitting recess may be approximately equal to thickness of the object to be electroplated.

In such a configuration, the object to be electroplated is fit into the fitting recess formed in the second insulated plate so that a surface of the object to be electroplated facing the first insulated plate and a surface of the second insulated plate facing the first insulated plate can be kept flat. Therefore, thickness of the inner seal attached to the object to be electroplated can be equal to thickness of the outer seal attached to the second insulated plate so as to simplify manufacturing of the inner seal and the outer seal.

The electroplating apparatus may further include a temporarily affixing device which temporarily affixes the second insulated plate to the first insulated plate in advance before the air pressure in the space is made and kept negative.

In such a configuration, in vacuuming the air in the space surrounded by the first insulated plate, the second insulated plate, the inner seal, and the outer seal, the temporarily affixing device can temporarily affix the second insulated plate to the first insulated plate in advance before the air in the space is vacuumed by the pump. Accordingly, vacuuming the air in the space in this manner saves an operator from having to affix the second insulated plate to the first insulated plate with his/her hand.

### BRIEF DESCRIPTION OF THE DRAWINGS

FIG. 1 is a whole perspective view of an electroplating apparatus according to an embodiment of the present invention viewed from front.
FIG. 2 is a whole perspective view of an electroplating apparatus according to an embodiment of the present invention viewed from back.
FIG. 3 is an exploded perspective view showing a first insulated plate, an inner seal, an outer seal, and a cathode conductive plate according to an embodiment of the present invention.
FIG. 4 is an exploded perspective view showing a first insulated plate, a second insulated plate, and a wafer according to an embodiment of the present invention.
FIG. 5 is a back view of an electroplating apparatus according to an embodiment of the present invention.
FIG. 6 is an enlarged sectional view of the electroplating apparatus viewed from direction indicated by arrows VI-VI in FIG. 5.
FIG. 7 is a whole perspective view of an electroplating apparatus according to another form of the present embodiment viewed from front.
FIG. 8 is an exploded perspective view showing an electroplating apparatus in prior art.

### DESCRIPTION OF THE PREFERRED EMBODIMENTS

Here will be described embodiments of the present invention in detail, referring to the accompanied drawings as needed.

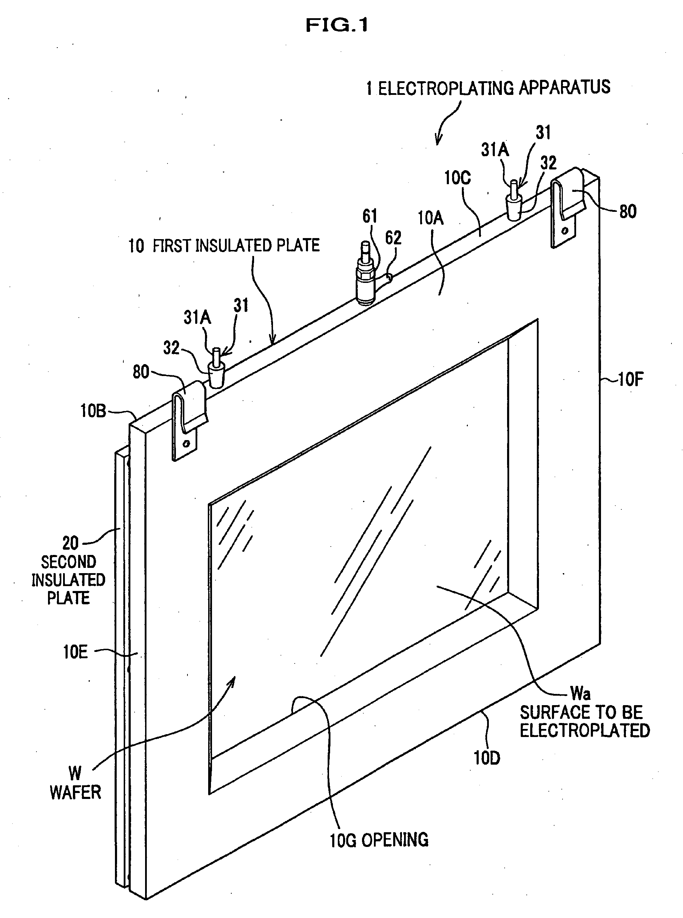

As shown in FIGs. 1-4, an electroplating apparatus 1 substantially includes a first insulated plate 10, a second insulated plate 20, a cathode conductive plate (a conductor) 30 which conducts electricity, an inner seal 40, an outer seal 50, and a vacuum passage 60.

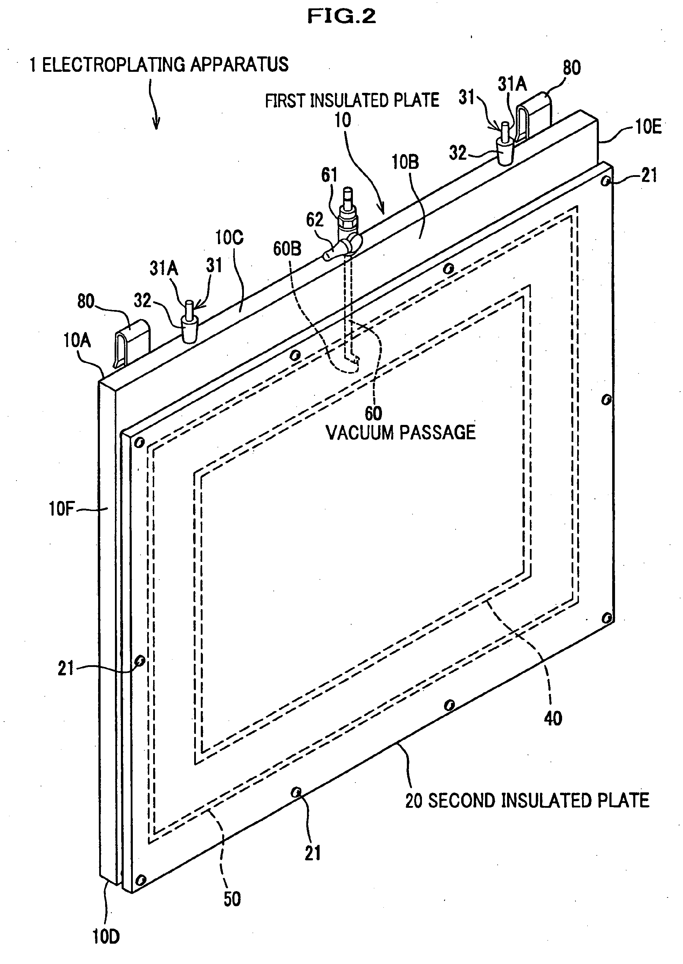

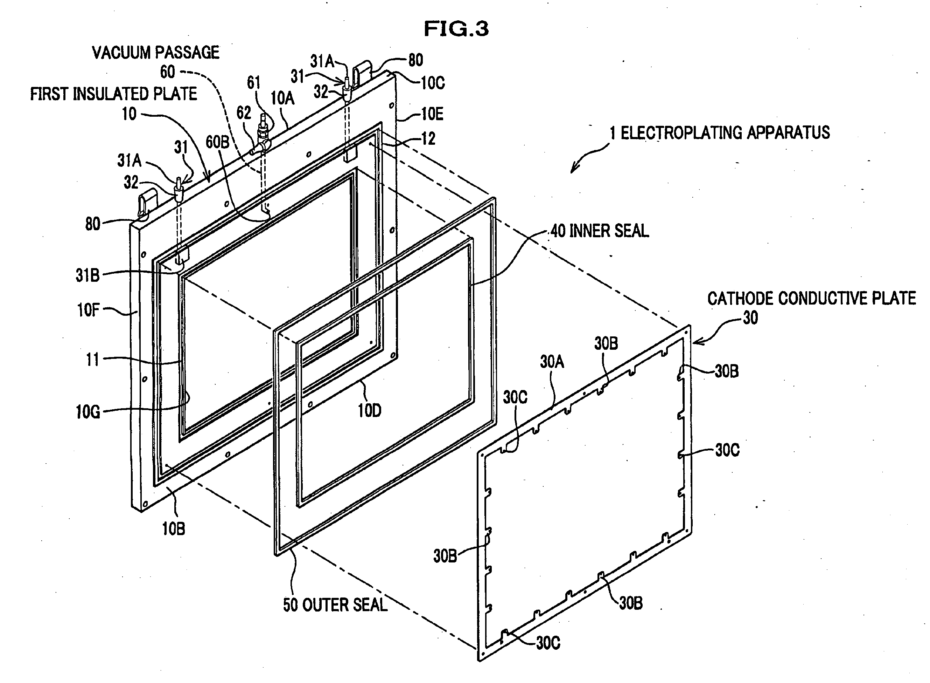

The first insulated plate 10 is, for example, a flat plate which is made of a insulated material such as an acryl plate and formed in a substantially rectangle shape. As shown in FIGs. 1 and 2, the first insulated plate 10 has a front surface 10A, a back surface 10B, a top surface 10C, a bottom surface 10D, a left side surface 10E, and a right side surface 10F. An opening 10G is formed in a substantially rectangle shape in the first insulated plate 10. Through the opening 10G, a surface Wa to be electroplated of a wafer W, which will be described later, is exposed. Moreover, as shown in FIG. 3, an inner seal fitting groove 11 is formed in a substantially rectangle shape so as to surround a periphery of the opening 10G on the back surface 10B of the first insulated plate 10. In addition, an outer seal fitting groove 12 is formed in a substantially rectangle shape so as to surround the inner seal fitting groove 11 on the back surface 10B of the first insulated plate 10.

Similarly to the first insulated plate 10, the second insulated plate 20 is, for example, a flat plate made of insulated material such as an acryl plate formed in a substantially rectangle shape. Additionally, as shown in FIG. 2, the second insulated plate 20 is temporarily affixed to the back surface 10B of the first insulated plate 10 using plural temporarily affixing screws 21, 21, ..., and 21, which are temporally affixing means.

Here, keeping air pressure in a space S surrounded by the first insulated plate 10, the second insulated plate 20, the inner seal 40, and the outer seal 50 negative allows the second insulated plate 20 to be pushed and affixed to the back surface 10B of the first insulated plate 10. The wafer W, which is an electrode plate and an object to be electroplated, is put between the first insulated plate 10 and the second insulated plate 20 so as to be exposed through the opening 10G of the first insulated plate 10.

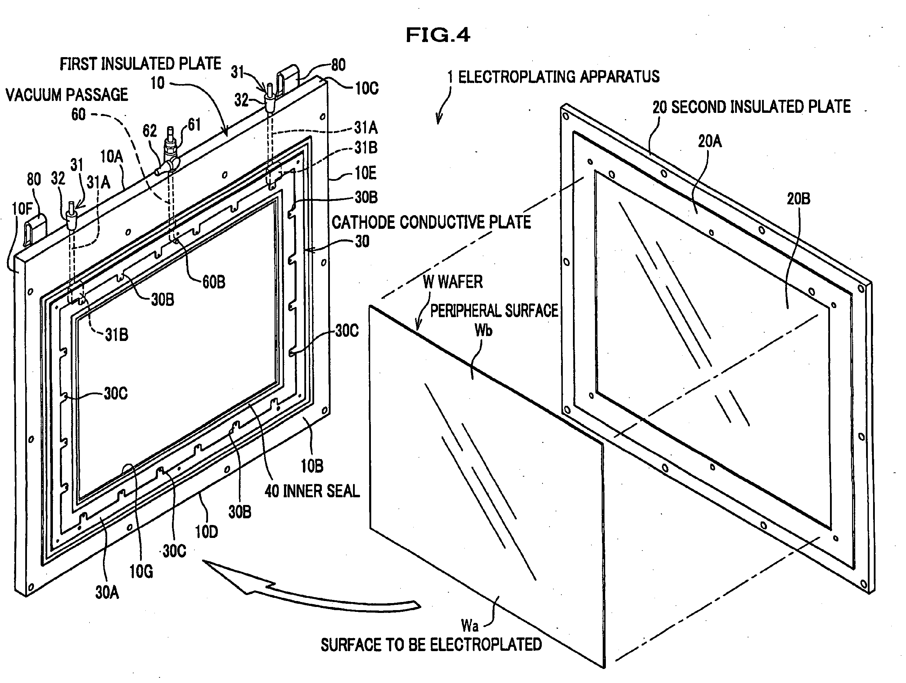

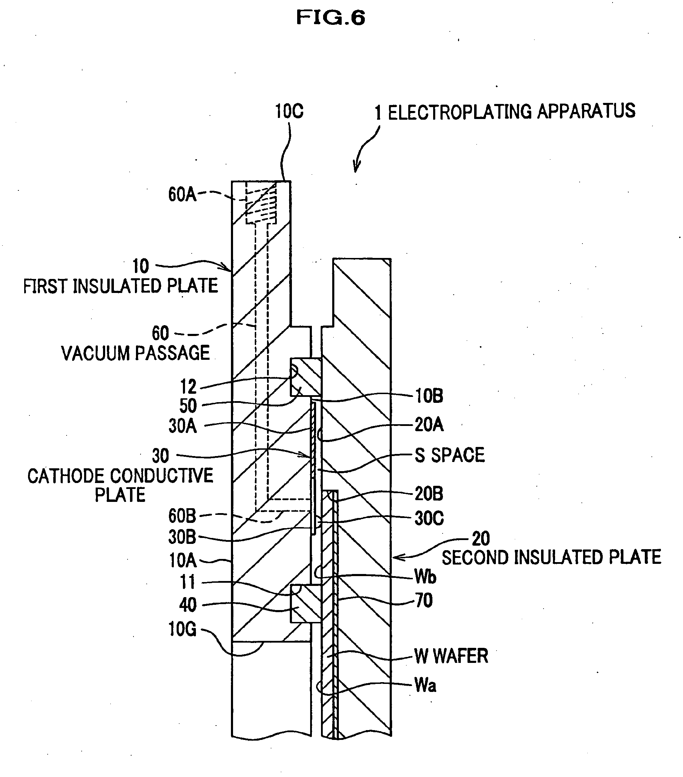

As shown in FIG. 4, a frame portion 20A is formed in a substantially rectangle shape integrally with a surface of the second insulated plate 20 facing the first insulated plate 10. Meanwhile, a fitting recess 20B which is a recess in a substantially rectangle shape and into which the wafer W is fit is formed inside the frame portion 20A formed in the second insulated plate 20. As shown in FIG. 6, depth of the fitting recess 20B is determined to be equal to thickness of the wafer W (for example, about 0.5-2 mm). Thus, a surface of the wafer W and a surface of the frame portion (raised surface) 20A of the second insulated plate 20 are substantially flat when the wafer W is fit into the fitting recess 20B of the second insulated plate 20.

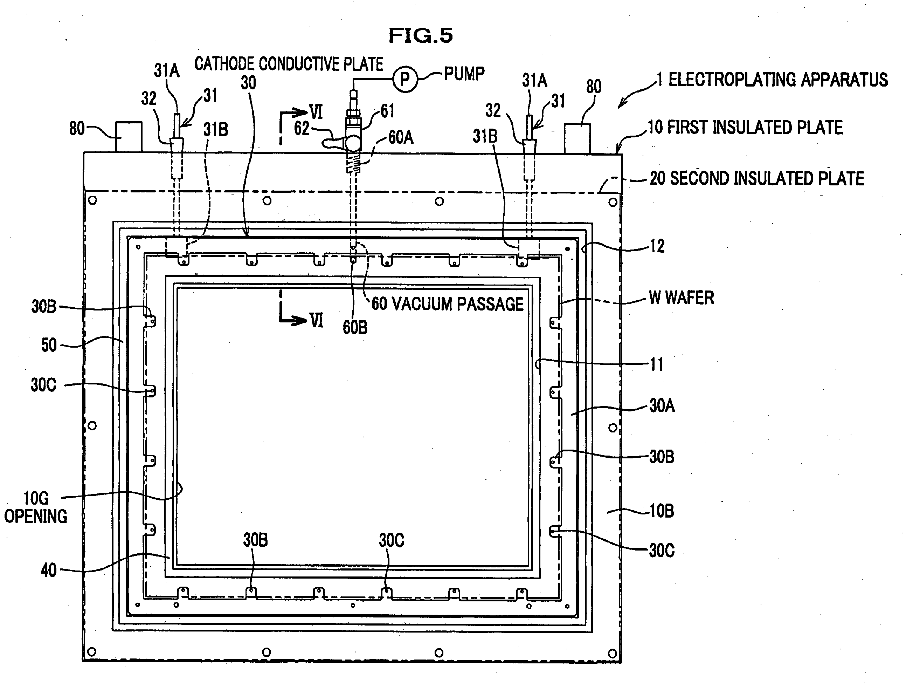

As shown in FIGs. 4-6, the cathode conductive plate 30 which is formed of a conductive material such as a copperplate and a stainless steel sheet, for example, is provided between the first insulated plate 10 and the second insulated plate 20. Moreover, the cathode conductive plate 30 includes a frame plate portion 30A which is formed in a substantially rectangle shape surrounding the wafer W, plural protruding plate portions 30B, 30B, ..., and 30B which protrude inward to a periphery of the wafer W from the frame plate portion 30A, and protruding portions 30C, 30C, ..., and 30C which are formed in a hemispherical shape and provided on an end of each of the protruding plate portions 30B so as to contact with the surface of the wafer W. In addition, the cathode conductive plate 30 is affixed on the back surface 10B of the first insulated plate 10 in such a way that the frame plate portion 30A is positioned between the inner seal fitting groove 11 and the outer seal fitting groove 12.

The cathode conductive plate 30 is connected to a negative electrode of a power source (not shown) through a pair of power connecting portions 31 and 31. Here, as shown in FIGs. 3 and 4, the power connecting portion 31 includes a metal rod 31A which extends downward inside the first insulated plate 10 from the top surface 10C of the first insulated plate 10, and a metal plate 31B which is provided at an end of the metal rod 31A in order to electrically contact with a surface of the frame plate portion 30A of the cathode conductive plate 30. Accordingly, the metal rod 31A of the power connecting portion 31 is electrically connected to the negative electrode of the power source so as to cause the cathode conductive plate 30 to conduct electricity to the wafer W. By the way, a number "32" shows a sealing member to seal between the metal rod 31A of the power connecting portion 31 and the first insulated plate 10. The sealing member 32 blocks electroplating solution from infiltrating into the space S surrounded by the first insulated plate 10, the second insulated plate 20, the inner seal 40, and the outer seal 50 through between the metal rod 31A and the first insulated plate 10.

As shown in FIGs. 3 and 6, the inner seal 40 is placed around a periphery of the opening 10G of the first insulated plate 10 between the first insulated plate 10 and the wafer W. As shown in FIG. 3, the inner seal 40 is formed of resin or the like as a frame plate whose cross section is substantially rectangle so as to fit in the inner fitting groove 11. Furthermore, the inner seal 40 is affixed to the surface of the wafer W with a sealing margin so as to block electroplating solution from infiltrating onto a peripheral surface Wb of the wafer W, especially contact portions between the peripheral surface Wb and the protruding portions 30C of the cathode conductive plate 30.

As shown in FIGs. 3 and 6, the outer seal 50 is provided between the first insulated plate 10 and the second insulated plate 20, surrounding the cathode conductive plate 30. Similarly to the inner seal 40, the outer seal 50 is also formed of resin or the like as a frame plate whose cross section is substantially rectangle so as to fit in the outer fitting groove 12. Thus, the outer seal 50 is affixed to the surface of the frame portion 20A of the second insulated plate 20 with a sealing margin so as to block electroplating solution from infiltrating onto the peripheral surface Wb of the wafer W, and so on, in combination with the inner seal 40.

As shown in FIGs. 2 and 6, the vacuum passage 60 extends vertically inside the first insulated plate 10. An end (upper end) of the vacuum passage 60 forms a tapped hole 60A and opens to the top surface 10C of the first insulated plate 10. The other end (lower end) of the vacuum passage 60 is bent in a substantially L-shape and forms an open end 60B so as to open to the space S surrounded by the first insulated plate 10, the second insulated plate 20, the inner seal 40, and the outer seal 50. Additionally, a joint 61 is screwed into the tapped hole 60A of the vacuum passage 60 in order to connect the vacuum passage 60 to a pump P. Inside the joint 61, an open/close valve (not shown) which connects the vacuum passage 60 to the pump P and disconnects the vacuum passage 60 from the pump P is included. Additionally, a lever 62 is also provided to operate the open/close valve. Thus, when the pump P is operated and the open/close valve is opened by the lever 62, air in the space S is vacuumed by the pump P through the vacuum passage 60 so as to make and keep the air pressure in the space S negative.

In FIG. 6, a number "70" shows a rubber sheet which covers a back surface of the wafer W and affixed inside the fitting recess 20B of the second insulated plate 20. The rubber sheet 70 pushes the wafer W toward the inner seal 40 so as to improve the sealing performance between the wafer W and the inner seal 40. In addition, in FIGs. 1-5, a number "80" shows a hook to hook the electroplating apparatus 1 to a rim of a solution tank inside which electroplating solution is filled in order to keep the wafer W being immersed in the electroplating solution while the wafer W is being electroplated.

In the embodiment described above, the pump P vacuums the air in the space S surrounded by the first insulated plate 10, the second insulated plate 20, the inner seal 40, and the outer seal 50 through the vacuum passage 60 so as to make and keep the air pressure in the space S negative. Consequently, the whole inner seal 40 is affixed to the wafer W with even pushing pressure (bearing stress) while the whole outer seal 50 is affixed to the second insulated plate 20 with even pushing pressure (bearing stress).

Thus, high sealing performance of the inner seal 40 and the outer seal 50 is maintained so as to solve a problem that electroplating solution infiltrates into the space S to cause an area (for example, the peripheral surface Wb) other than the wafer surface Wa to be electroplated or that the wafer W is stuck to the protruding portion 30C of the cathode conductive plate 30 since an area between the wafer W and the protruding portion 30C is electroplated. Accordingly, only the surface Wa of the wafer W is exactly electroplated so as to improve performance and reliability of the electroplating apparatus 1. In addition, even when a larger sized electroplating apparatus 1 is manufactured as the wafer W is getting larger, it is possible to make and keep the air pressure in the space S negative. Therefore, the whole inner seal 40 can be affixed to the wafer W with even pushing pressure (bearing stress) while the whole outer seal 50 is affixed to the second insulated plate 20 with even pushing pressure (bearing stress). As a result, the performance and the reliability of the electroplating apparatus 1 are further improved.

In the present embodiment, the open/close valve is included inside the joint 61 which connects the pump P to the vacuum passage 60. Therefore, when the pump P vacuums the air in the space S, the open/close valve is opened by the lever 62 in order to connect the vacuum passage 60 to the pump P to make and keep the air pressure in the space S negative. Then, after the air pressure in the space S has become negative, the open/close valve is closed by the lever 62 in order to disconnect the vacuum passage 60 from the pump P so that no air enters into the space S. Consequently, the open/close valve can keep the air pressure in the space S negative without keeping the pump P working so as to save fuel expense for operating the pump P.

Moreover, the depth of the fitting recess 20B of the second insulated plate 20 is determined to be approximately equal to the thickness of the wafer W so as to keep the surface of the wafer W and the surface of the frame portion 20A of the second insulated plate 20 flat. Accordingly, it is possible to make the thickness of the inner seal 40 which attaches to the wafer W to be equal to the thickness of the outer seal 50 which attaches to the second insulated plate 20 so as to simplify manufacturing of the inner seal 40 and the outer seal 50.

Furthermore, the second insulated plate 20 is temporarily affixed to the back surface 10B of the first insulated plate 10 using plurality of the temporarily affixing screws 21, 21, ..., and 21 in advance before the air pressure in the space S is made and kept negative. Therefore, the pump P can vacuum the air in the space S in a state where the second insulated plate 20 is temporarily affixed to the first insulated plate 10 in advance. Thus, it is possible to save an operator from having to affix the second insulated plate 20 to the first insulated plate 10 with his/her hand, so as to improve workability.

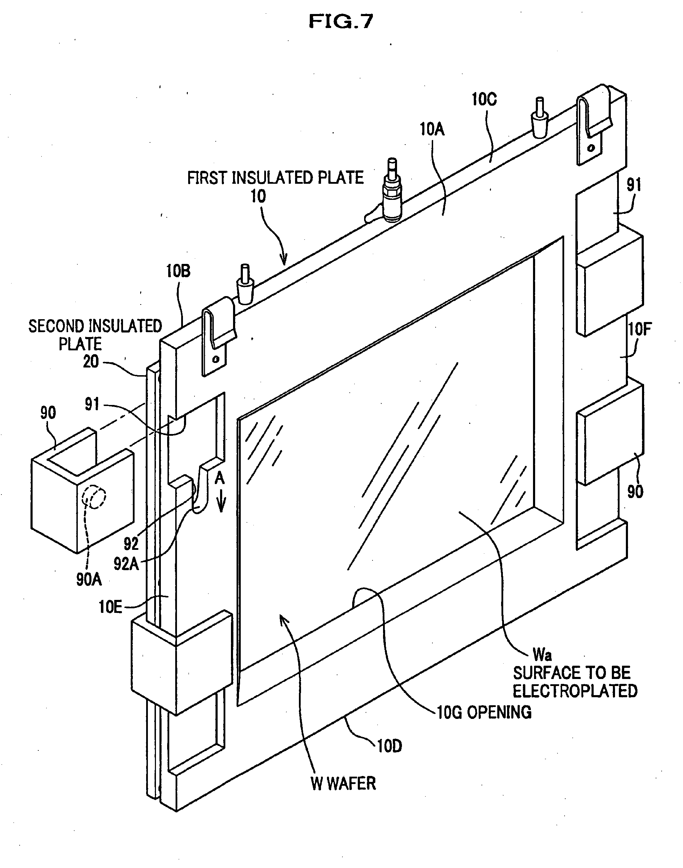

Although a case where plural screws are used as temporarily affixing means to temporarily affix the first insulated plate 10 to the second insulated plate 20 is described as an example in the present embodiment, the present invention is not limited to this. For example, in another form of the embodiment shown in FIG. 7, an insulated plate clip member 90 formed in a substantially U-shape may be fixed in a fitting recess 91 formed in the front surface 10A of the first insulated plate 10. Then, a protruding portion 90A protruding toward inside of the insulated plate clip member 90 may be made to slide in vertical direction (direction of the arrow A shown in FIG. 7) on a sliding groove 92 connected to the fitting recess 91 in order to temporarily affix the first insulated plate 10 to the second insulated plate 20. Here, the sliding groove 92 becomes gradually deeper in direction of the arrow A so that the protruding portion 90A slides to the deepest end 92A of the sliding groove 92 and then the insulated plate clip member 90 is fixed.

Moreover, although a case of providing two power connection portions 31 is described as an example in the present embodiment, the present invention is not limited to this. For example, three power connection portions 31 or only one power connection portion 31 may be provided.

According to the present invention, the air pressure in the space surrounded by the first insulated plate, the second insulated plate, the inner seal, and the outer seal is kept negative to maintain high sealing performance of the inner seal and the outer seal. Consequently, the object to be electroplated other than the surface to be electroplated can be certainly prevented from being electroplated so as to improve the performance and the reliability of the electroplating apparatus.

## Claims

1. An electroplating apparatus comprising:
a first insulated plate (10) which has an opening (10G);
a second insulated plate (20) for holding an object (W) to be electroplated between the first insulated plate (10) and the second insulated plate (20) in such a way that the object (W) is exposed through the opening (10G);
an inner seal (40) provided around the periphery of the opening (10G);
a conductor (30) provided between the first insulated plate (10) and the second insulated plate (20) and surrounding the object (W) in order to conduct electricity to the object (W);
an outer seal (50) provided between the first insulated plate (10) and the second insulated plate (20), surrounding the conductor (30); and
a vacuum passage (60) formed inside the first insulated plate (10) and/or the second insulated plate (20) in order to make and keep a negative air pressure in a space (S) surrounded by the first insulated plate (10), the second insulated plate (20), the inner seal (40), and the outer seal (50),
**characterised in that**
the second insulated plate (20) has a fitting recess (20B) for receiving the object (W) to be electroplated, and
the inner seal (40) is disposed between the first insulated plate (10) and the object (W) to be electroplated.

2. The apparatus of claim 1, comprising an open/close valve in the vacuum passage (60) for connecting/disconnecting the vacuum passage (60) to/from a pump (P).

3. The apparatus of claim 1 or 2, wherein the depth of the fitting recess (20B) is approximately equal to thickness of the object (W) to be electroplated.

4. The apparatus of any one of claims 1-3, further comprising means (21) for temporarily affixing the second insulated plate (20) to the first insulated plate (10) before the air pressure in the space (S) is made and kept negative.

5. The apparatus of any preceding claim, wherein the conductor (30) is provided between the inner seal (40) and the outer seal (50).

## Patentansprüche

1. Vorrichtung zur Elektroplattierung mit
einer ersten isolierten Platte (10) mit einer Öffnung (10G),
einer zweiten isolierten Platte (20), die einen zu plattierenden Gegenstand (W) zwischen der isolierten Platte (10) und der zweiten isolierten Platte (20) derart hält, dass der Gegenstand (W) durch die Öffnung (10G) hindurch frei liegt,
einer den Rand der Öffnung (10G) umgebenden inneren Dichtung (40), einem zwischen der ersten und der zweiten isolierten Platte (10, 20) vorgesehenen Leiter (30), der den Gegenstand (W) umgibt, um ihm Elektrizität zuzuführen,
einer zwischen der ersten und der zweiten isolierten Platte (10, 20) vorgesehenen und den Leiter (30) umgebenden äußeren Dichtung (50) und
einem Vakuumkanal (60), der innerhalb der ersten und/oder der zweiten isolierten Platte (10, 20) ausgebildet ist, um in einem von der ersten und der zweiten isolierten Platte (10, 20) sowie der inneren und der äußeren Dichtung (40, 50) umgebenden Raum (S) einen Luftunterdruck (S) herzustellen und zu halten, **dadurch gekennzeichnet, dass**
die zweite isolierte Platte (20) eine Passaussparung (20B) zur Aufnahme des zu plattierenden Gegenstands (W) aufweist und
die innere Dichtung (40) zwischen der ersten isolierten Platte (10) und dem zu plattierenden Gegenstand (W) angeordnet ist.

2. Vorrichtung nach Anspruch 1 mit einem in dem Vakuumkanal (60) liegenden Auf/Zu-Ventil zum Anschluss des Vakuumkanals (60) an eine Pumpe (P) sowie zum Trennen dieses Anschlusses.

3. Vorrichtung nach Anspruch 1 oder 2, wobei die Tiefe der Passaussparung (20B) etwa gleich der Dicke des zu plattierenden Gegenstands (W) ist.

4. Vorrichtung nach einem der Ansprüche 1 bis 3 mit ferner einer Einrichtung (21) zum vorübergehenden Befestigen der zweiten isolierenden Platte (20) an der ersten isolierenden Platte (10), bevor der Luftdruck in dem Raum (S) erzeugt und hergestellt wird.

5. Vorrichtung nach einem der vorhergehenden Ansprüche, wobei der Leiter (30) zwischen der inneren und der äußeren Dichtung (40, 50) vorgesehen ist.

## Revendications

1. Dispositif d'électroplacage comprenant :
une première plaque isolée (10) qui a une ouverture (10G) ;
une deuxième plaque isolée (20) pour maintenir un objet (W) à électroplaquer entre la première plaque isolée (10) et la deuxième plaque isolée (20) de telle sorte que l'objet (W) soit exposé à travers l'ouverture (10G) ;
un joint d'étanchéité interne (40) prévu autour de la périphérie de l'ouverture (10G) ;
un conducteur (30) prévu entre la première plaque isolée (10) et la deuxième plaque isolée (20) et entourant l'objet (W) afin de conduire l'électricité jusqu'à l'objet (W) ;
un joint d'étanchéité externe (50) prévu entre la première plaque isolée (10) et la deuxième plaque isolée (20), entourant le conducteur (30) ; et
un passage de mise en dépression (60) formé à l'intérieur de la première plaque isolée (10) et/ou la deuxième plaque isolée (20) afin de produire et de maintenir une pression d'air négative dans un espace (S) entouré par la première plaque isolée (10), la deuxième plaque isolée (20), le joint d'étanchéité interne (40) et le joint d'étanchéité externe (50),
**caractérisé en ce que**
la deuxième plaque isolée (20) a un évidement de montage (20B) pour recevoir l'objet (W) à électroplaquer, et
le joint d'étanchéité interne (40) est disposé entre la première plaque isolée (10) et l'objet (W) à électroplaquer.

2. Dispositif selon la revendication 1, comprenant une vanne d'ouverture / fermeture du passage de mise en dépression (60) pour la connexion / déconnexion du passage de mise en dépression (60) vis-à-vis d'une pompe (P).

3. Dispositif selon la revendication 1 ou 2, dans lequel la profondeur de l'évidement de montage (20B) est approximativement égale à l'épaisseur de l'objet (W) à électroplaquer.

4. Dispositif selon l'une quelconque des revendications 1 à 3, comprenant en outre des moyens (21) pour la fixation temporaire de la deuxième plaque isolée (20) à la première plaque isolée (10) avant que la pression d'air dans l'espace (S) soit rendue et maintenue négative.

5. Dispositif selon l'une quelconque des revendications précédentes, dans lequel le conducteur (30) est prévu entre le joint d'étanchéité interne (40) et le joint d'étanchéité externe (50).
